# EUROPEAN PATENT APPLICATION

(11) **EP 1 981 073 A2**
(43) Date of publication of application: **15.10.2008**
(21) Application number: 08161430.7
(22) Date of filing: 11.11.1999
(51) Int. Cl.: H01L 21/3065, C23C 16/455, H01L 21/67

(54) **Surface treatment method and surface treatment apparatus**

(30) Priority: 11.11.1998 JP 32047898
(62) Divisional of application: 99122000.5
(71) Applicant: Tokyo Electron Limited, Tokyo 107-8481 (JP)
(72) Inventor: Kobayashi, Yasuo, Tokyio Electron Limited, Intell. Depmt, Tokyo 107-8481 (JP); Miyatani, Kotaro, Tokyio Electron Limited, Intell. Depmt, Tokyo 107-8481 (JP); Maekawa, Kaoru, Tokyio Electron Limited, Intell. Depmt, Tokyo 107-8481 (JP)
(74) Representative: HOFFMANN EITLE

(57) **Abstract**

A subject (W) which is to be treated and on which an oxide film is formed, is carried into a treatment vessel (10), and the treatment vessel is maintained under vacuum. A mixture gas of N₂ gas and H₂ gas is introduced into a plasma generation section (30), plasma is generated, and activated gas species of the N₂ and H₂ gases are formed. The activated gas species are caused to flow toward the subject, and an NF₃ gas is added to the activated gas species and activated to generate an activated gas of N₂, H₂ and NF₃ gases. The subject (W) is cooled to not higher than a predetermined temperature by a cooling means and reacted with the activated gas of NF₃ gas. The oxide film is thus degenerated into a reactive film. When the supply of N₂, H₂ and NF₃ gases into the treatment vessel (10) is stopped, the subject is heated up to a predetermined temperature by a heating means, and the reactive film is sublimated and eliminated. Thus, a surface treatment method for removing the oxide film from the subject and a surface treatment apparatus for doing the same are disclosed. Furthermore, the surface treatment apparatus and other treatment apparatuses constitute a cluster system capable of carrying the subject in an unreactive atmosphere.

## Description

The present invention relates to a surface treatment method for removing an oxide film and a contaminant, especially a native oxide film and an oxide, from the surface of a subject to be treated, such as a semiconductor wafer, and a surface treatment apparatus for doing the same.

In a general manufacturing process of a semiconductor integrated circuit (referred to as a semiconductor device hereinafter), a substrate to be treated, such as a semiconductor wafer, repeatedly undergoes predetermined deposition and pattern etching to form a number of semiconductor devices on the substrate.

In order to treat a subject such as a semiconductor wafer (referred to as a wafer hereinafter), the wafer needs to be carried between treatment apparatuses. It was therefore actually difficult to prevent a wafer from being exposed to the atmosphere. When a wafer was exposed to the atmosphere, its surface reacted with oxygen and moisture in the atmosphere to easily form a so-called native oxide film thereon. Moreover, it was likely that a contaminant such as a chemical oxide would be adhered to the surface of the wafer due to the atmosphere, treatment gas, treatment liquid and the like during various types of treatment.

The above native oxide film and contaminant degrade the characteristics of semiconductor devices, such as electrical characteristics. To avoid this, surface treatment for removing a native oxide film or the like from the surface of a wafer is carried out as pre-treatment for deposition on the wafer.

As the pre-treatment, wet cleaning was generally adopted in which a wafer is soaked into chemicals to remove a native oxide film from the surface of the wafer. As semiconductor devices are improved in degree of integration, the device size such as trace widths, and diameters of contact holes or via holes, is decreased. For example, the aspect ratio of a contact hole is increased and the diameter thereof is decreased down to 0.2 µm to 0.3 µm or smaller (e.g., 0.12 µm). Because of such a scale-down structure, in the above wet cleaning, chemicals were neither soaked sufficiently into the small contact hole nor discharged therefrom due to surface tension, thus causing a serious problem in which a native oxide film could not be completely removed from the bottom of the contact hole or a water mark was produced.

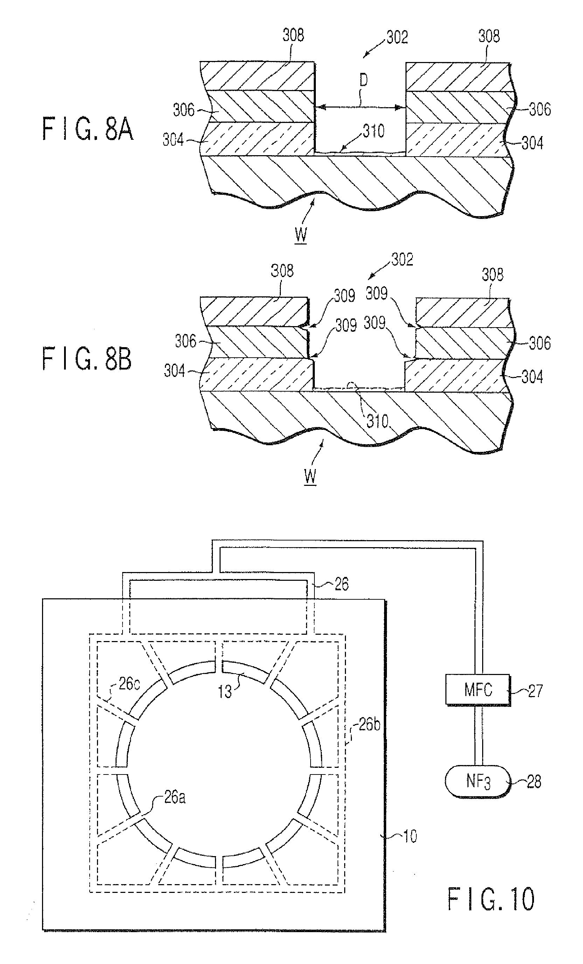

The following problem was also caused. When a subject to be treated, which has a multilayer structure including a plurality of layers, undergoes wet cleaning, the wall of a contact hole becomes irregular since the layers constituting the wall vary in etching rate. FIGS. 8A and 8B illustrate a contact hole 302 which electrically contacts drain and source regions. The diameter D of the contact hole 302 shown in FIG. 8A ranges from 0.2 µm to 0.3 µm. The wall of the contact hole 302 has, as shown in FIG. 8A, a multilayer structure of, e.g., three silicon oxide (SiO) films formed by a plurality of deposition steps. The three-layer structure includes a first SiO film 304 formed by thermal oxidation, a second SiO₂ film 306 constituted of a phosphorus-doped glass by the spin coat technique, and a third SiO film 308 constituted of silica glass. Referring to FIG. 8A, a native oxide film 310 is generated at the bottom of the contact hole 302.

The rate of etching using chemicals varies from layer to layer in the wet cleaning. The conventional wet cleaning has the following drawback. After the wet cleaning is performed to remove a native oxide film 310, as shown in FIG. 8B, irregularities 309 occur on the side-walls of the contact hole 302 due to variations in etching rate and a boundary between adjacent layers is etched excessively (see the cut portions) since the chemicals are easy to enter the boundary.

In order to resolve the above drawback of the conventional wet cleaning, a method of removing a native oxide film from a subject to be treated using etching gas, i.e., a so-called dry cleaning (etching) method is proposed in, for example, Jpn. Pat. Appln. KOKAI Publications Nos. 5-275392, 6-338478, and 9-106977.

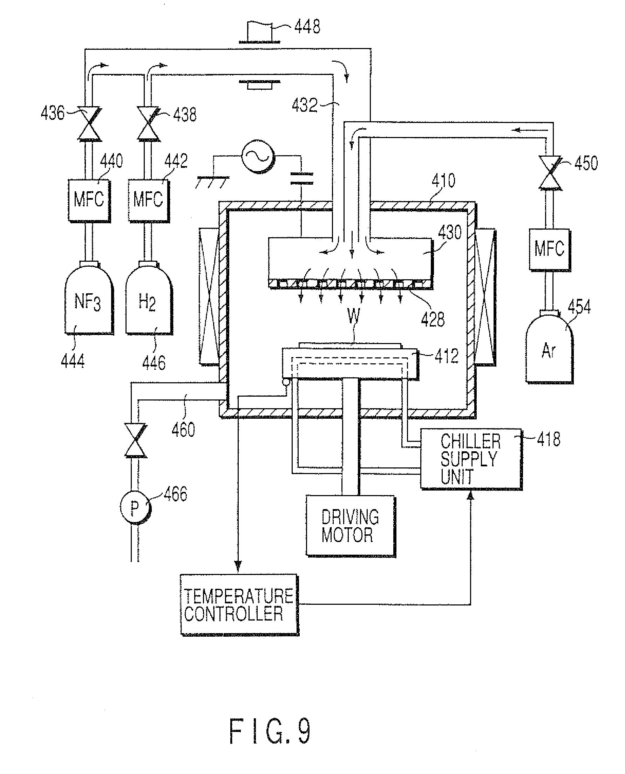

FIG. 9 shows a prior art dry etching apparatus for dry-etching an SiO₂ film by the dry cleaning method as disclosed in the above No. 5-275392 Publication. The dry cleaning method for eliminating a native oxide film from a subject to be treated, will now be described with reference to FIG. 9 showing the dry etching apparatus.

In the apparatus shown in FIG. 9, an open/close valve 450 is closed to cut off Ar gas from an Ar-gas source 454. Open/close valves 436 and 438 are opened to supply NF₃ gas and H₂ gas from an NF₃-gas source 444 and an H₂-gas source 446 to a pipe 432 by controlling their flow rates by means of flow-rate controllers (MFC) 440 and 442. In the pipe 432, both the NF₃ gas and H₂ gas are mixed at a mixing ratio of 1:2 into a mixed gas having a total pressure of 0.2 Torr. A 2.45-GHz-frequency, 50-w-power microwave is supplied from a magnetron into the pipe 432 via a microwave waveguide 448, and the mixed gas thus becomes plasma therein. A fluorine active species F*, a hydrogen active species H*, and a nitrogen active species N*, which are generated by the plasma, move toward a chamber 410 within the pipe 432 and enter a buffer chamber 430 of the chamber 410. These species are then supplied downstream through a porous plate 428 onto a wafer W placed on a susceptor 412. The wafer W is cooled by a chiller which is supplied from a chiller supply unit 418 and cooled to not higher than room temperature. The active species F*, H* and N* supplied to the cooled wafer W, are adsorbed by the native oxide film on the surface of the wafer W and react to SiO into a product. This product is vaporized and exhausted from an exhaust nozzle 460 provided at the bottom of the chamber 410 by a vacuum pump 466.

In the foregoing prior art method of removing a native oxide film from the surface of a cooled wafer by fluorine, hydrogen and nitrogen active species F*, H* and N* produced by plasma (Jpn. Pat. Appln. KOKAI Publication No. 5-275392), NF₃ is changed into plasma and thus dissolved into fluorine and nitrogen active species F* and N*, so that no NF₃ active gas can be generated efficiently. Since, moreover, H₂ has difficulties in maintaining the plasma state by itself, it is difficult to secure an etching rate enough to remove the native oxide film.

In another method of removing a native oxide film by dry cleaning (Jpn. Pat. Appln. KOKAI Publications Nos. 6-338478 and 9-106977), it is also difficult to secure an etching rate enough to remove a native oxide film since an H₂ gas is used alone.

Accordingly, the object of the present invention is to provide a surface treatment method and a surface treatment apparatus which resolve the problems of the prior art oxide-film removing method described above. In the present invention, in order to remove an oxide film having a thickness of 10Å to 20Å from the surface of a subject to be treated, H₂ and N₂ gases are mixed into plasma gas, and an NF₃ gas (a reactive gas) is added to the plasma during the flow of active species of the mixture gas. The subject to be treated is cooled to not higher than room temperature, and the oxide film on the subject reacts with the reactive gas to form a reactive film. After that, the subject to be treated is heated to a given temperature or higher, and the reactive film is removed from the surface of the subject.

The invention provides a method according to claim 1 and an apparatus according to claim 3. Preferred embodiments of the invention are indicated in the dependent claims.

Also according to the present invention, there is provided a surface treatment method comprising the steps of:
carrying a subject to be treated, which has an oxide on a surface thereof, into a treatment vessel;
evacuating the treatment vessel to produce a vacuum;
introducing gas containing N and H into a plasma generation section, generating plasma from the gas, and activating the plasma to generate an activated gas species of N and H;
causing the activated gas species to flow toward the subject and adding an NF₃ gas to the activated gas species to generate an activated gas of NF₃ gas;
cooling the subject to not higher than a predetermined temperature; and
reacting the activated gas of NF₃ gas with the oxide on the surface of the subject to degenerate the oxide into a reactive film.

Preferably, in the above surface treatment method, the gas containing N and H is a mixture gas of N₂ and H₂ gases, and the method further comprises the steps of:
stopping supply of N₂, H₂ and NF₃ gases into the treatment vessel and heating the subject to a predetermined temperature to sublimate the reactive film, after the step of degenerating the oxide into the reactive film; and
stopping evacuation of the treatment vessel and taking the subject, from which an oxide film is removed, out of the treatment vessel.

Preferably, in the above surface treatment method, the predetermined temperature at which the subject is cooled, is not higher than room temperature.

Preferably, in the above surface treatment method, the predetermined temperature at which the subject is cooled, ranges from 0°C to -20°C.

Preferably, in the above surface treatment method, the predetermined temperature at which the subject is cooled, ranges from 10°C to -20°C.

Preferably, in the above surface treatment method, the predetermined temperature at which the reactive film is sublimated, is not lower than 100°C.

Also according to the present invention, there is provided a surface treatment apparatus comprising:
a plasma generation section for generating plasma from a plasma generating gas;
a treatment vessel connected to the plasma generation section and including a susceptor on which a subject to be treated is placed;
cooling means for cooling the subject placed on the susceptor to a predetermined temperature;
lifting means for lifting the subject to a heating position in the treatment vessel; and
heating means for heating the subject to a predetermined temperature in the heating position.

Preferably, the above surface treatment apparatus is an apparatus for removing a native oxide film from a surface of the subject to be treated.

Preferably, the above surface treatment apparatus further comprises:
a plasma generating gas introduction section for introducing N₂ and H₂ gases to the plasma generation section as a plasma generating gas; and
an NF₃-gas supply section for adding an NF₃ gas to an activated gas species of N₂ and H₂ gases activated by the plasma generation section and caused to flow toward the subject to be treated, and
an activated gas of NF3 gas is generated by adding the NF3 gas to the activate gas species, and the activated gas is reacted with a surface layer of the subject to degenerate the surface layer.

Preferably, in the above surface treatment apparatus, the predetermined temperature at which the subject placed on the susceptor is cooled, is not higher than room temperature.

Preferably, in the above surface treatment apparatus, the predetermined temperature at which the subject placed on the susceptor is cooled, ranges from 20°C to -20°C.

Preferably, in the above surface treatment apparatus, the predetermined temperature at which the subject placed on the susceptor is cooled, ranges from 10°C to -20°C.

Preferably, in the above surface treatment apparatus, the predetermined temperature at which the subject is heated at the heating position, is not lower than 100°C.

Preferably, in the above surface treatment apparatus, the NF₃-gas supply section includes a number of gas exhaust holes formed in an inner wall of the treatment vessel.

Preferably, in the above surface treatment apparatus, the NF₃-gas supply section includes a ring-shaped or grid-shaped shower head having a number of gas exhaust holes provided in the treatment vessel.

Preferably, in the above surface treatment apparatus, the NF₃-gas supply section supplies the NF₃ gas to the activate gas species in position at least 20 cm away from an end of the plasma generation section in a direction of the subject to be treated.

Preferably, in the above surface treatment apparatus, the heating means is heat radiation means provided above the subject to be treated.

Preferably, in the above surface treatment apparatus, the heating means is a heating lamp provided above the subject to be treated.

According to a third aspect of the present invention, the surface treatment apparatus of the above second aspect comprises a cluster system including at least one metal-wiring forming chamber, a heating chamber, and a load-lock chamber such that the subject is carried through a carrier chamber in an unreactive atmosphere.

Preferably, the above cluster system includes at least one metal-wiring forming chamber, a heating chamber, a cooling chamber, and a load-lock chamber such that the subject is carried through a carrier chamber in an unreactive atmosphere.

Preferably, in the above cluster system, the metal-wiring forming chamber is a chamber for forming a film of at least one of Al, Ti, TiN, Si, W, WN, Cu, Ta, TaN and SiN.

Preferably, in the above cluster system, the metal-wiring forming chamber includes means for heating the subject to a temperature of 100°C or higher.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a schematic block diagram showing a surface treatment apparatus according to an embodiment of the present invention;
FIG. 2A is a plan view of one example of a wafer lifting mechanism which can be applied to the surface treatment apparatus shown in FIG. 1;
FIG. 2B is a side view of the wafer lifting mechanism shown in FIG. 2A;
FIG. 3A is a plan view showing a ring-shaped shower head as an alternative to an NF₃-gas supply section (shower head) which is applicable to the surface treatment apparatus of FIG. 1;
FIG. 3B is a plan view showing a grid-like shower head as an alternative to the NF₃-gas supply section which is applicable to the surface treatment apparatus of FIG. 1, the grid-like shower head being viewed from the susceptor side;
FIG. 4 is a flowchart of respective steps of a surface treatment method according to the present invention;
FIG. 5A is an enlarged view showing a native oxide film adhered to a wafer in order to describe the surface treatment method of the present invention;
FIG. 5B is an enlarged view showing a reactive film formed on the surface of the wafer in order to describe the surface treatment method of the present invention;
FIG. 5C is an enlarged, schematic view showing a mixture gas of Si, N, H, F and O, which is sublimated and removed from a protective film by heating of a lamp, in order to describe the surface treatment method of the present invention;
FIG. 6 is a conceptual diagram of a vacuum cluster system constituted by a combination of a heating unit and a wiring-forming unit when the surface treatment apparatus shown in FIG. 1 is employed as a native oxide film removing apparatus;
FIG. 7 is a conceptual diagram of a vacuum cluster system constituted by a combination of a heating unit, a wiring-forming unit and a cooling unit when the surface treatment apparatus shown in FIG. 1 is employed as a native oxide film removing apparatus;
FIG. 8A is an enlarged view showing a native oxide film adhered to the bottom of a contact hole of a wafer in order to describe a prior art surface treatment method of removing the native oxide film;
FIG. 8B is an enlarged, schematic view showing irregularities caused on the side wall of the contact hole due to variations in etching rate in order to describe the prior art surface treatment method;
FIG. 9 is a schematic view of a prior art etching apparatus which is applied to a method of removing a native oxide film by etching using a neutral gas species mixing NF₃ and H₂ gases;
FIG. 10 is a conceptual diagram illustrating an alternative to an NF₃-gas supply section which is applicable to the surface treatment apparatus of the present invention; and
FIG. 11 is a diagram showing a relationship between wafer-cooling temperature and etching rate.

A surface treatment method and a surface treatment apparatus according to an embodiment of the present invention will now be described with reference to the accompanying drawings.

First, the surface treatment (oxide removal) apparatus will be described.

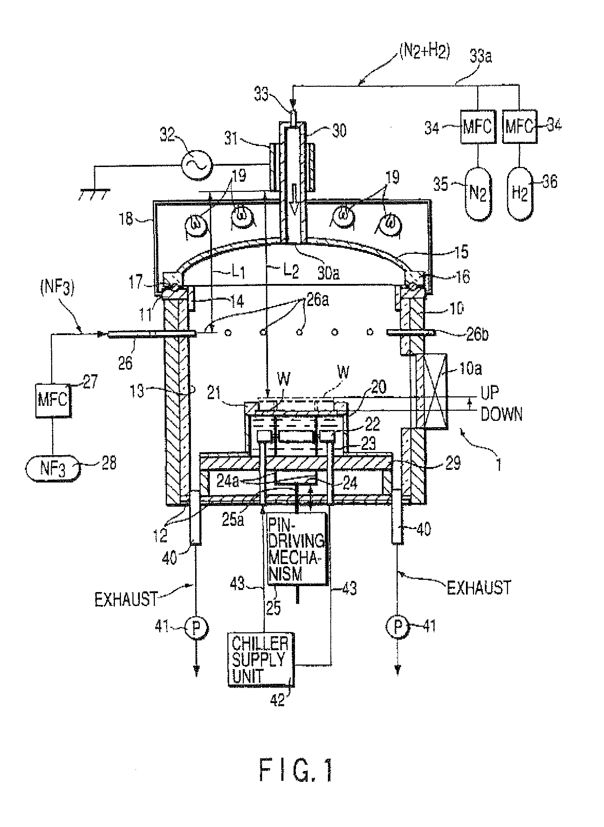

FIG. 1 is a conceptual block diagram of a surface treatment apparatus 1 according to the present invention. The apparatus 1 can be used for removing a contaminant having a thickness of 10Å to 20Å, which is caused on the surface of a subject to be treated. The contaminant is, for example, a native oxide film or a chemical oxide naturally adhered to or formed on the surface of the subject, and referred to as a native oxide film hereinafter. The subject to be treated is, for example, a semiconductor wafer and referred to as a wafer W hereinafter. As shown in FIG. 1, the surface treatment apparatus 1 comprises a plasma generation pipe 30 for generating plasma from a mixture of N₂ and H₂ gases and activating the plasma, a treatment vessel 10 for removing the native oxide film from the surface of the wafer W, and a reactive-gas supply pipe 26 for supplying an NF₃ gas (reactive gas) from an NF₃-gas source into the treatment vessel 10.

The treatment vessel 10 is constituted of aluminum materials and its inner wall is provided with quartz (SiO₂) linings 13 and 14 to be protected from metal pollution, erosion or the like. The treatment vessel 10 can be formed as a housing whose transverse plane may have various shapes such as a circle, a square and a polygon. A bottom plate 12 having a predetermined thickness is fixed to the bottom of the treatment vessel 10. A base 29 is disposed on the bottom plate 12, and a cylindrical susceptor 20 is provided on the base 29. The wafer W is placed on the top of the susceptor 20 and clamped by a quartz-made clamp ring 21. A jacket (or a pipe) 22 for holding a chiller and a heat exchanger 23 are included in the susceptor 20. The jacket 22 and heat exchanger 23 can be formed integrally as one component. The chiller is supplied from a chiller supply unit 42 into the jacket 22 through a cooling pipe 43 to cool the wafer W down to a given temperature, such as a temperature not higher than room temperature.

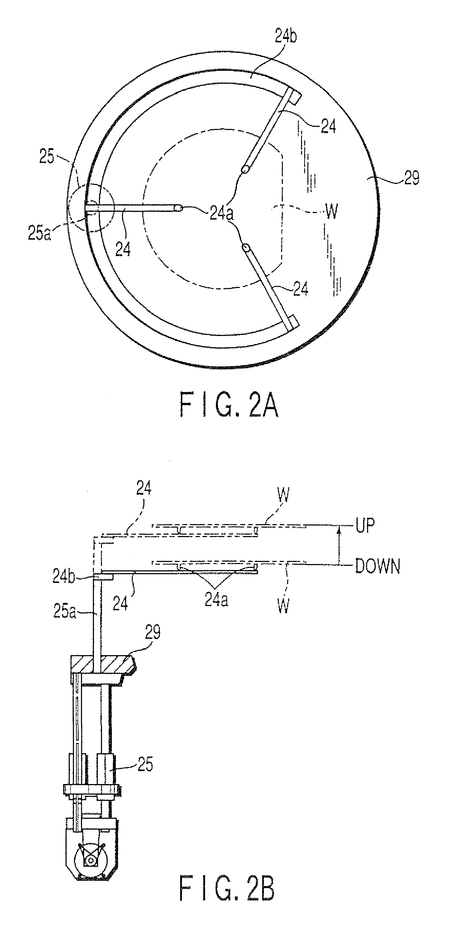

The susceptor 20 is provided with a wafer-lifting means. The wafer-lifting means is a mechanism for lifting the wafer W up to a given heating position (L2) from the susceptor 20 to heat the wafer W and, after predetermined treatment, lowering the wafer W and returning it on the susceptor 20, and includes a pin-driving mechanism 25, supporting pins 24a, and arms 24. An example of the wafer-lifting means is illustrated in FIGS. 2A and 2B. The pin-driving mechanism (hydraulic cylinder) 25 is disposed under the base 29 formed at the bottom of the treatment vessel 10, and a horseshoe supporting piece 24b is fixed to the end portion of a cylinder rod 25a of the cylinder 25. The arms 24 extend inward along the radial direction of the wafer W, and the supporting pins 24a are fixed to their respective points (three points) of the arms 24. The supporting pins 24a each have an upward-protruding peak portion at one end, and the wafer W is thus held horizontally by these three peak portions of the supporting pins 24a. To heat the wafer W using a heat radiation means (a heating lamp) 19, it is lifted up to the heating position (L2) shown in FIG. 1.

Exhaust pipes (e.g., four exhaust pipes) 40 are arranged on the periphery of the bottom plate 12 fixed to the bottom of the treatment vessel 10. An exhaust means (e.g., a vacuum pump) 41 is connected to these exhaust pipes 40 to evacuate the treatment vessel 10 to produce vacuum.

A top plate 11 (made of, e.g., aluminum materials) is fixed to the top of the treatment vessel 10. A quartz-made cover (dome) 15 having a flange section 16 is formed on the top plate 11, with a sealing member (e.g., a rubber-made O-shaped ring) 17 interposed therebetween. The cover 15 can be formed integrally with the quartz-made plasma generation pipe 30 as one component and may have various shapes such as a flat one and a domed one. Monitor devices such as a pressure sensor can be provided at a sealing section including the sealing member 17. These monitor devices monitor a sealing pressure of the sealing section, a gas leak from the sealing section, and the like.

A number of heating lamps 19 are provided above the cover 15 as a heat radiation means for heating the wafer W from above. As the heating lamps 19, halogen lamps can be employed such that the wafer W can be heated quickly. The heat waves radiated from the heating lamps 19 enter the surface of the wafer W lifted up to the heating position, through the transparent quartz-made dome 15, thereby heating the wafer W up to a temperature of 100°C or higher (e.g., 120°C) .

Since the heating lamps 19 are covered with a cover 18 made of metal or the like, they can be prevented from radiating heat waves and light rays to the outside and, even when the quartz-made dome 15 is broken, plasma gas or reactive gas can be prevented from diffusing and leaking to the outside.

A gate valve 10a is provided on the side wall of the treatment vessel 10 to communicate with a carrier chamber, a load-lock chamber, and the like. The gate valve 10a is opened and closed when the wafer W is carried in and out.

Usually the inner surface of the gate valve 10a need not be protected by quartz because the metal surface of the treatment vessel 10 is hardly etched by NF₃ gas. Coating of the metal surface with quartz is generally performed in order that the metal surface can prevent the lifetime of species activated by plasma from being shortened. In this sense, it is favorable to coat the inner surface of the gate valve 10a with quartz, too.

The quartz-made plasma generation pipe 30 can be provided in the upper central part of the quartz-made cover 15 integrally with each other by melting contact, and it is opened to the treatment vessel 10 in the center of the cover 15 to introduce plasma into the vessel 10. For generation and introduction of plasma, any structure capable of uniform surface treatment can be adopted. For example, plasma can be introduced from an opening shifted from the center of the cover 15 or from the side of the treatment vessel 10.

An introduction section 33 for introducing a plasma generating gas is connected to the upper end portion of the plasma generation pipe 30. Both N₂ and H₂ gases are supplied from N₂ and H₂ gas sources 35 and 36 to a gas passage 33a through a flow-rate controller (MFC) 34. A mixture (N₂+H₂) of these gases is supplied to a plasma generation section of the plasma generation pipe 30 inside a plasma cavity 31 through the introduction section 33.

A microwave generator 32 is connected to the plasma cavity 31. A microwave of, e.g., 2.45 GHz, which is generated from the microwave generator 32, is applied to the plasma cavity 31 to excite the plasma generating gas in the plasma generation pipe 30, activate the mixture of N₂ and H₂ gases, and form active gas species of N* and H* radicals. These active gas species are introduced into the treatment vessel 10 from an opening 30a of the plasma generation pipe 30.

A number of gas exhaust nozzles 26a for supplying an NF₃ gas are arranged in position L₁ under the opening 30a of the plasma generation pipe 30. The position L1 is at least 20 cm or more, preferably 30 cm or more away from the lower end of the plasma cavity 31 of the plasma generation pipe 30 (plasma generation section). A given amount of NF₃ gas is supplied to the gas exhaust nozzles 26a through an NF₃-gas source 28, a flow-rate controller (MFC) 27, a conduction pipe 26, a pipe 26b surrounding the outer wall of the treatment vessel 10, and a conduction pipe 26c penetrating the wall of the vessel 10.

The gas exhaust nozzles 26a shown in FIG. 1 are protruded slightly inward from the inner wall of the treatment vessel 10. However, neither the gas exhaust nozzles 26a nor the gas supply section from the conduction pipe 26 to the gas exhaust nozzles 26a is limited to the structure shown in FIG. 1. Another gas supply section is illustrated in FIG. 10. Referring to FIG. 10, a pipe 26b and conduction pipes 26c are provided in the treatment vessel 10 made of aluminum. These pipes 26b and 26c can be formed integrally with the inner wall of the treatment vessel 10. Gas exhaust nozzles 26a are provided so as not protrude from the inner wall of the vessel 10, which allows gas to be diffused uniformly in the treatment vessel 10 and does not disturb a flow of plasma from the upper reaches.

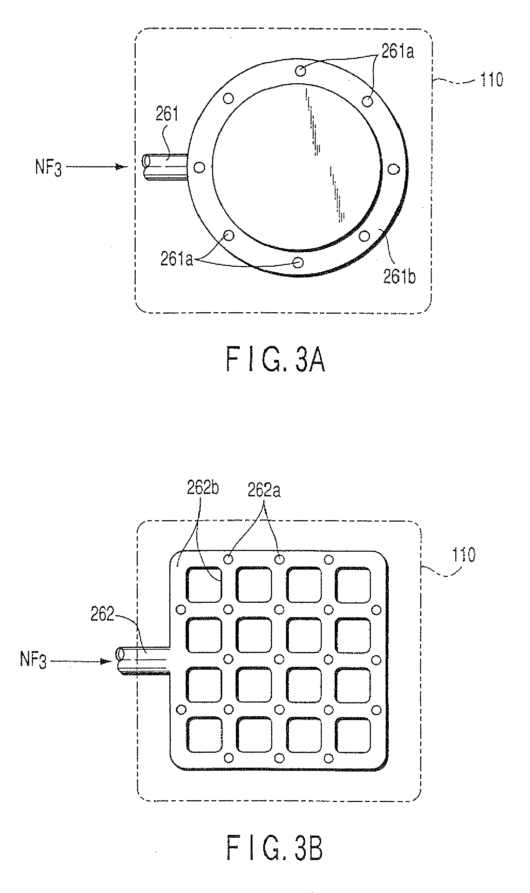

A shower head 261b is illustrated in FIG. 3A as an alternative to the gas exhaust nozzles 26a shown in FIG. 1. The shower head 261b is shaped like a ring and made of quartz. The shower head 261b has a number of gas exhaust nozzles 261a. These nozzles 261a are arranged on the circumference of the shower head 261b so as to be directed in the downward direction (in the direction of the susceptor 20), the lateral direction, or the slanting direction. A conduction pipe 261 is connected to the ring-shaped shower head 261a. The shower head 261a is located horizontally in a given position within the treatment vessel 10 to supply NF₃ gas into the treatment vessel 10.

FIG. 3B shows a grid-like shower head 262b having a number of gas exhaust nozzles 262a. In this shower head 262b, too, the gas exhaust nozzles 262a can be arranged in the downward direction, lateral direction, or the slanting direction.

Furthermore, a means (not shown) for regulating the flow of plasma gas can be provided at the opening 30a of the plasma generation tube 30. The regulating means can be formed as a cylindrical or umbrella cover which is opened from the opening 30a toward the susceptor 20.

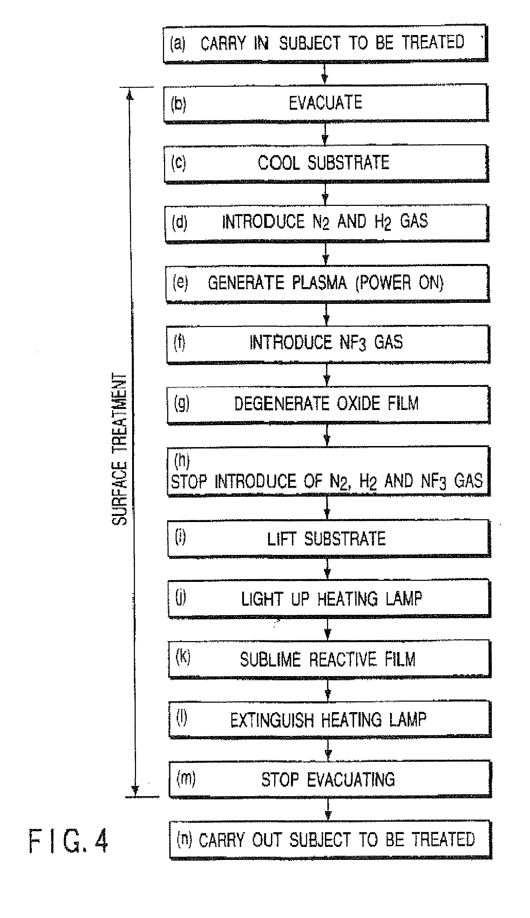

A method of treating a surface (removing a native oxide film) by the foregoing surface treatment apparatus, will now be described with reference to the flowchart of FIG. 4.

### STEP (a):

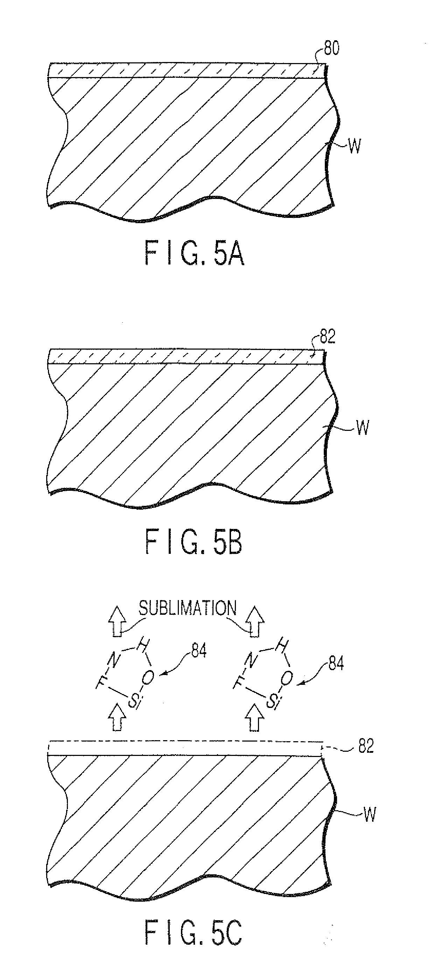

When the gate valve 10a of the surface treatment apparatus 1 shown in FIG. 1 is opened, a single wafer W is carried from the carrier chamber into the treatment vessel 10 through the gate valve 10a in an unreactive atmosphere (e.g., in a vacuum), placed on the susceptor 20, and clamped to the susceptor 20 by the clamp ring 21. In the preceding step, a contact hole 302 is formed in the wafer W as shown in FIG. 8A, and an oxide 80 such as a native oxide film is formed at the bottom of the contact hole 302 as shown in FIG. 5A.

### STEP (b):

After the wafer W is inserted into the treatment vessel 10, the gate valve 10a is closed. The vessel 10 is evacuated through the exhaust pipes 40 by means of the vacuum pump 41 to produce a vacuum atmosphere of 1 mTorr or lower (133 Pa or lower).

### STEP (c):

The wafer W is cooled to room temperature or lower by the chiller supplied from the chiller supply unit 42 to the susceptor 20.

### STEP (d):

N₂ (nitrogen) and H₂ (hydrogen) gases are supplied from the N-gas and H-gas sources 35 and 36 to the gas passage 33a, under the control of their flow rates through the flow-rate controller (MFC) 34, to generate a mixture gas (N₂+H₂), and the mixture gas is then supplied from the plasma gas introduction section 33 to the plasma generation pipe 30 as a plasma generating gas.

### STEP (e):

A microwave (2.54 GHz) is generated from the microwave generator 32 and introduced into the cavity formed around the plasma generation section of the plasma generation pipe 30. The microwave causes plasma to be produced from the mixture gas (N₂+H₂). The plasma is activated to form active gas species of N* and H* radicals. In particular, the H₂ gas, which is originally hard to become plasmatic, can be changed into plasma with efficiency and then activated, together with the N₂ gas. The active gas species N* and H* are attracted to the vacuum atmosphere in the treatment vessel 10 and caused to flow from the plasma generating section of the pipe 30 toward the opening (outlet) 30a thereof.

### STEP (f):

A reactive gas NF₃ is supplied from the NF₃-gas source 28, provided outside the treatment vessel 10, to the reactive-gas conduction pipe 26 through the flow-rate controller (MFC) 27 and then supplied from the gas exhaust holes 26a into the treatment vessel 10 like a shower. The NF₃ gas is added to the active gas species of N* and H* radicals generated by the plasma of N₂ and H₂ gases flowing from the opening 30a of the plasma generation pipe 30. The added NF₃ gas is thus activated by these active gas species N* and H*.

### STEP (g):

By the activation of NF₃ gas and the synergistic effect of active gas species N* and H*, the native oxide film 80 of the wafer W shown in FIG. 5A is degenerated into a reactive film 82 mixing Si, N, H, F and O, as shown in FIG. 5B. When the native oxide film 80 is degenerated, a chiller (e.g., ethylene glycol) is supplied into the susceptor 20 by the chiller supply unit 42, and the wafer W placed on the susceptor 20 is cooled to not higher than room temperature.

This cooling increases the rate of etching using the NF₃ active gas. As process conditions for the above treatment, it is preferable that the flow rates of H₂, NF₃ and N₂ be 10 sccm, 30 sccm and 100 sccm, respectively, process pressure be 3 Torr, plasma power be 50W, and process time be about 3 minutes.

Since the etching rate of etching species generated by reaction of NF₃ and H₂ gases is low, these gases are adsorbed by the etching surface to determine the etching rate. If the wafer is cooled down to not higher than room temperature, the above adsorbing rate is increased and so is the etching rate.

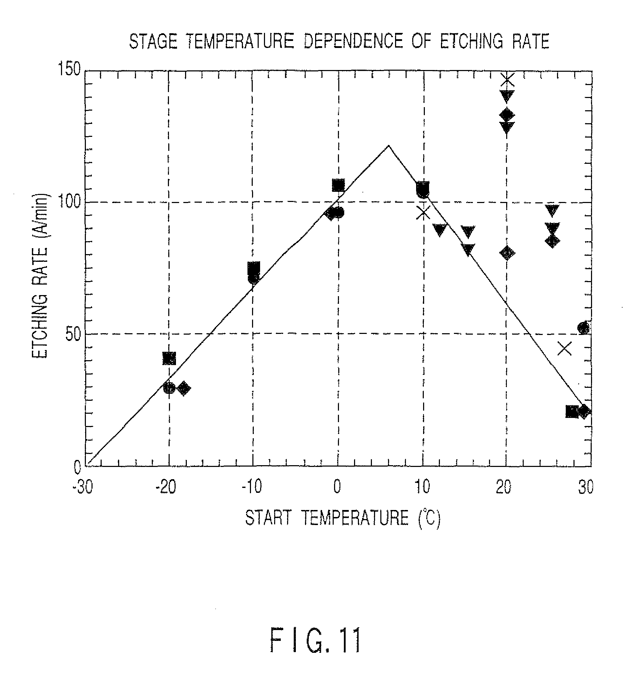

As described above, it is preferable that the step of degenerating the native oxide film 80 on the wafer W by the activation of NF₃ gas and the synergistic effect of active gas species N* and H* be executed at a temperature which is not higher than room temperature. FIG. 11 shows a relationship between cooling temperature and etching rate in the degenerating step with respect to six cases. In this figure, the ordinate indicates the etching rate, while the abscissa does the cooling temperature of the wafer W at the start of the step. As is apparent from FIG. 11, since the control characteristic of etching becomes unstable when the cooling temperature exceeds 20°C, it is preferable that the cooling temperature be not higher than room temperature and range from 20°C to -20°C and from 10°C to -20°C. The data shown in FIG. 11 is obtained under the following experimental conditions: In the step of degenerating the native oxide film 80, ratio of H₂/NF₃/N₂ is 300:60:400 sccm, pressure is 4 Torr, power is 300W, and process time is 1 minute. In the sublimation step, temperature is 140°C, time is 1 minute, and atmosphere is vacuum.

### STEP (h):

After the native oxide film 80 is degenerated, the supply of H₂, N₂ and NF₃ gases is stopped, as is the driving of the microwave generator 32, thereby stopping the introduction of microwaves into the plasma generation pipe 30. The treatment vessel 10 is evacuated through the exhaust pipes 40 to produce vacuum.

### STEP (i):

The wafer-lifting means is driven to lift the wafer W up to the heating position at least 5 mm away from the susceptor 20.

### STEP (j):

When the heating lamp 19 lights up, the wafer W is heated from above and its surface is quickly heated to a temperature of 100°C or higher (e.g., 120°C) from room temperature.

### STEP (k):

The reactive film 82 mixing Si, N, H, F and O is sublimated as gas 84 mixing Si, N, H, F and O by the heating lamp 19, as shown in FIG. 5C, and then eliminated and exhausted from the exhaust pipes 40. By this sublimation, the native oxide film 80 (reactive film 82) is removed from the wafer W and thus silicon (Si) appears on the surface of the wafer W. As the process conditions for this step, it is preferable that process pressure is 1 mTorr or lower and process time is about 2 minutes.

### STEP (1):

The heating lamp 19 is extinguished.

### STEP (m):

Finally, the evacuation is stopped.

### STEP (n):

The gate valve 10a is opened, and the wafer-lifting means is driven to lower the wafer W and return it on the susceptor 20. The wafer W from which the native oxide film is removed, is taken out of the treatment vessel 10 and carried to its next chamber (e.g., a carrier chamber) in a vacuum atmosphere.

The above oxide film includes not only SiO₂ but also W, Ti, Al, Ni and Co and a very thin oxide film (10Å to 20Å) grown on silicide of these elements.

The surface treatment apparatus of the present invention constitutes a multi-chamber cluster system in combination with other treatment units such as a metal-wiring forming chamber, a heating chamber, a cooling chamber, a carrier chamber and a load-lock chamber. The constitution of the cluster system will now be described.

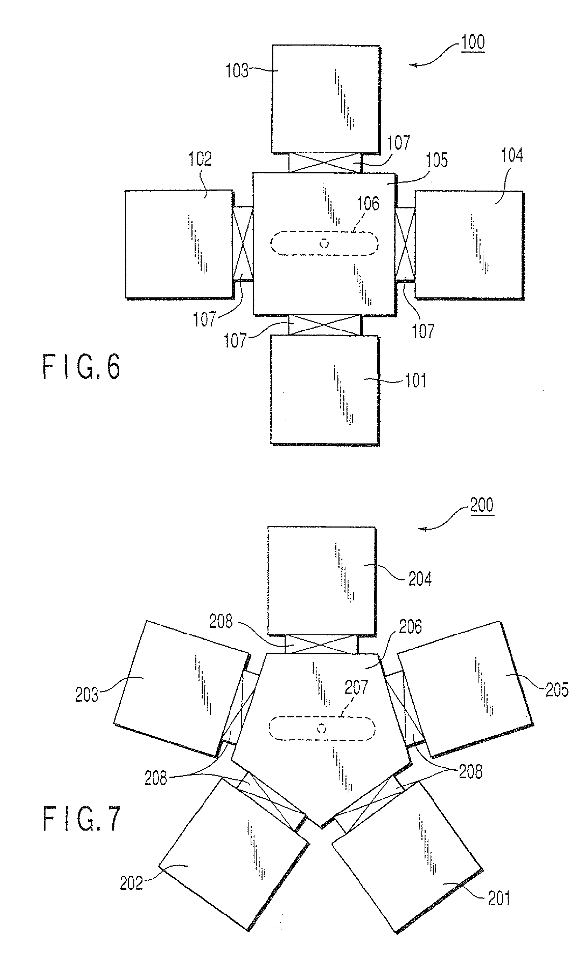

FIG. 6 shows a vacuum cluster system 100 capable of carrying a wafer in an unreactive atmosphere (e.g., a vacuum atmosphere). The system 100 includes a native oxide film removing chamber 101 which corresponds to the surface treatment apparatus of the present invention. A heating chamber 102, at least one metal-wiring forming chamber 103, and a load-lock chamber 104 are connected to the chamber 101 through a carrier chamber 105. The metal-wiring forming chamber 103 forms metal wirings of Al, Ti, TiN, Si, W, WN, Cu, Ta and SiN on a subject to be treated by metal CVD. A gate valve 107 is interposed between adjacent chambers, and a carrier robot 106 is provided in the carrier chamber 105.

A wafer cassette containing wafers is transported into the load-lock chamber 104, and the wafers are carried in the carrier chamber 105 and aligned with reference to their orientation flats. When the gate valve 107 is opened, the carrier robot 106 carries the wafers into the native oxide film removing chamber 101 one by one. In the chamber 101, an oxide film is removed from the surface of each of the wafers, and the wafers are pre-heated in the heating chamber 102. After that, in the metal-wiring forming chamber 103, metal wirings such as Al and Ti are formed in the contact holes of the wafers by metal CVD. Finally, the wafers are returned to the load-lock chamber 104.

FIG. 7 illustrates a vacuum cluster system 200 capable of carrying a wafer in an unreactive atmosphere. The system 200 includes a native oxide film removing chamber 201 corresponding to the surface treatment apparatus of the present invention. A heating chamber 202, at least one metal-wiring forming chamber 203, a cooling chamber 204, and a load-lock chamber 205 are connected to the chamber 201 through a carrier chamber 206. A gate valve 208 is interposed between adjacent chambers, and a carrier robot 207 is provided in the carrier chamber 206.

In order to carry the wafers on which metal wirings are formed, from the chamber 203 which is usually heated to a temperature of about 500°C, to the load-lock chamber 205, the wafers need to be cooled to a temperature (about 150°C) at which the chamber 205 can receive the wafers.

In the vacuum cluster systems shown in FIGS. 6 and 7, if the heating chambers 102 and 202 have a means for heating the wafers to a temperature of 100°C or higher, the heating means of the native oxide film removing chambers 101 and 201 can be excluded.

The vacuum cluster systems so constituted have the advantages that a native oxide film can be prevented from being regenerated while the wafers are being carried in the atmosphere, time from removal of a native oxide film to deposition need not be controlled, a water mark can be prevented from being produced, a native oxide film can be removed from the wafer in situ, and throughput is greatly improved.

In the above-described surface treatment method and surface treatment apparatus according to the present invention, gas containing N and H is activated as plasma gas to form an active gas species. The active gas species activates a reactive gas (NF₃ gas) and cools a subject to be treated to not higher than room temperature. These three gases are reacted with an oxide film formed on the surface of the subject to degenerate the oxide film into a reactive film. If the reactive film is sublimated by heating, the oxide film such as a native oxide film can be removed from the surface of the subject with high efficiency and at a high etching rate.

In the foregoing embodiment, N₂ and H₂ gases are employed as a gas containing N and H. This gas can be replaced with another gas such as ammonium.

Furthermore, the shower head for jetting an activated gas is shaped like a ring or a grid. However, any other structure can be adopted for the shower head.

The surface treatment apparatus of the present invention and other treatment apparatuses constitute a cluster system capable of carrying a subject to be treated in an unreactive atmosphere or in a vacuum. Therefore, no oxide film is formed on a wafer while the wafer is being carried, and the system throughput is enhanced as a whole.

The invention also relates to the following items:
1. A surface treatment method characterized by comprising the steps of:
   carrying a subject (W) to be treated, which has an oxide on a surface thereof, into a treatment vessel (10);
   evacuating the treatment vessel to produce a vacuum;
   introducing gas containing N and H into a plasma generation section (30), generating plasma from the gas, and activating the plasma to generate an activated gas species of N and H (35, 36);
   causing the activated gas species to flow toward the subject and adding an NF₃ gas to the activated gas species to generate an activated gas of NF₃ gas (28);
   cooling the subject to not higher than a predetermined temperature; and
   reacting the activated gas of NF₃ gas with the oxide on the surface of the subject to degenerate the oxide into a reactive film.
2. The surface treatment method according to item 1, characterized in that the gas containing N and H is a mixture gas of N₂ and H₂ gases, and the method further comprises the steps of:
   stopping supply of the N₂, H₂ and NF₃ gases into the treatment vessel and heating the subject to a predetermined temperature to sublimate the reactive film, after the step of degenerating the oxide into the reactive film; and
   stopping evacuation of the treatment vessel and taking the subject, from which an oxide film is removed, out of the treatment vessel.
3. The surface treatment method according to item 1, characterized in that the predetermined temperature at which the subject is cooled, is not higher than room temperature.
4. The surface treatment method according to item 1, characterized in that the predetermined temperature at which the subject is cooled, ranges from 20°C to - 20°C.
5. The surface treatment method according to item 1, characterized in that the predetermined temperature at which the subject is cooled, ranges from 10°C to - 20°C.
6. The surface treatment method according to item 2, characterized in that the predetermined temperature at which the reactive film is sublimated, is not lower than 100°C.
7. A surface treatment apparatus characterized by comprising:
   a plasma generation section (30) for generating plasma from a plasma generating gas (35, 36);
   a treatment vessel (10) connected to the plasma generation section and including a susceptor (20) on which a subject (W) to be treated is placed;
   cooling means (22, 23) for cooling the subject placed on the susceptor to a predetermined temperature;
   lifting means (24, 24a, 25) for lifting the subject to a heating position in the treatment vessel; and
   heating means (19) for heating the subject to a predetermined temperature in the heating position.
8. The surface treatment apparatus according to item 7, characterized in that is an apparatus for removing a native oxide film from a surface of the subject to be treated.
9. A surface treatment apparatus according to item 7, characterized by further comprising:
   a plasma generating gas introduction section (33) for introducing N₂ and H₂ gases to the plasma generation section as a plasma generating gas; and
   an NF₃-gas supply section for adding an NF₃ gas to an activated gas species of N₂ and H₂ gases activated by the plasma generation section and caused to flow toward the subject to be treated,
   wherein an activated gas of NF3 gas is generated by adding the NF3 gas to the activate gas species, and the activated gas is reacted with a surface layer of the subject to degenerate the surface layer.
10. The surface treatment apparatus according to item 7, characterized in that the predetermined temperature at which the subject placed on the susceptor is cooled, is not higher than room temperature.
11. The surface treatment apparatus according to item 7, characterized in that the predetermined temperature at which the subject placed on the susceptor is cooled, ranges from 20°C to -20°C.
12. The surface treatment apparatus according to item 7, characterized in that the predetermined temperature at which the subject placed on the susceptor is cooled, ranges from 10°C to -20°C.
13. The surface treatment apparatus according to item 7, characterized in that the predetermined temperature at which the subject is heated at the heating position, is not lower than 100°C.
14. The surface treatment apparatus according to item 9, characterized in that the NF₃-gas supply section includes a number of gas exhaust holes (26a) formed in an inner wall (13) of the treatment vessel.
15. The surface treatment apparatus according to item 9, characterized in that the NF₃-gas supply section includes a shower head (261b, 262b) having a number of gas exhaust holes provided in the treatment vessel.
16. The surface treatment apparatus according to item 9, characterized in that the NF₃-gas supply section supplies the NF₃ gas to the activate gas species in position at least 20 cm away from an end of the plasma generation section in a direction of the subject to be treated.
17. The surface treatment apparatus according to item 7, characterized in that the heating means is heat radiation means provided above the subject to be treated.
18. The surface treatment apparatus according to item 7, characterized in that the heating means is a heating lamp provided above the subject to be treated.
19. The surface treatment apparatus according to item 7, characterized by comprising a cluster system (200) including at least one metal-wiring forming chamber (103), a heating chamber (102), and a load-lock chamber (104) such that the subject is carried through a carrier chamber (105) in an unreactive atmosphere.
20. The surface treatment apparatus according to item 7, characterized by comprising a cluster system including at least one metal-wiring forming chamber, a heating chamber, a cooling chamber, and a load-lock chamber such that the subject is carried through a carrier chamber in an unreactive atmosphere.
21. The surface treatment apparatus according to one of items 19 and 20, characterized in that the metal-wiring forming chamber is a chamber for forming a film of at least one of Al, Ti, TiN, Si, W, WN, Cu, Ta, TaN and SiN.
22. The surface treatment apparatus according to one of items 19 and 20, characterized in that the metal-wiring forming chamber includes means for heating the subject to a temperature of 100°C or higher.

## Claims

1. A method of treating a subject (W) to be treated, which is placed on a susceptor (20) and has an oxide film on a surface thereof, comprising the steps of:
introducing gas containing N and H from a gas introduction section (33);
activating the gas containing N and H to generate a first activated gas species by a plasma generation section (30);
adding reactive gas to the first activated gas species by a gas supply means (26, 26b) to generate a second activated gas species; and
supplying the second activated gas species to the surface of the subject (W), and by reacting it with the oxide film on the surface, forming a reactive film on the subject,
wherein the second activated gas species generation step is the step of supplying the reactive gas in a lateral or slanting direction with respect to the direction of the surface of the subject (W), in a position between the plasma generation section (30) and the surface of the subject (W), so that the additive gas is added to the first activated gas species to generate the second activated gas species.

2. The method of treating a subject to be treated according to claim 1, **characterized by** further comprising a step of heating the subject (W) to sublimate the reactive film.

3. An apparatus (1) which treats a subject (W) to be treated, which is placed on a susceptor (20) and has an oxide film on a surface thereof, comprising:
a gas introduction section (33) which introduces gas containing N and H;
a plasma generation section (30) which activates the gas containing N and H to generate a first activated gas species; and
a gas supply means (26, 26b) which adds additive gas to the first activated gas species to generate a second activated gas species,
wherein the apparatus (1) supplies the second activated gas species to the surface of the subject (W), and by reacting it with the oxide film on the surface, forms a reactive film on the subject,
wherein the gas supply means (26, 26b) supplies the reactive gas in a lateral or slanting direction with respect to the surface of the subject (W), in a position between the plasma generation section (30) and the surface of the subject (W), and by adding the additive gas to the first activated gas species, the second activated gas species is generated.

4. The surface treatment apparatus according to claim 3, **characterized by** further comprising heating means (19) for sublimating the reactive film by heating the subject (W).
